## Europäisches Patentamt

## European Patent Office

## Office européen des brevets

(11) Numéro de publication: **0 190 243**
**B1**

(12) **FASCICULE DE BREVET EUROPEEN**

(45) Date de publication du fascicule du brevet:
**12.04.89**

(51) Int. Cl.⁴: **H 01 L 21/76**, H 01 L 21/28,
**H 01 L 21/60**

(21) Numéro de dépôt: **85903842.4**

(22) Date de dépôt: **29.07.85**

(86) Numéro de dépôt international:
**PCT/FR 85/00208**

(87) Numéro de publication internationale:
**WO 86/01336 (27.02.86 Gazette 86/5)**

(54) **PROCEDE DE FABRICATION D'UN CIRCUIT INTEGRE DE TYPE MIS.**

(30) Priorité: **03.08.84 FR 8412300**

(43) Date de publication de la demande:
**13.08.86 Bulletin 86/33**

(45) Mention de la délivrance du brevet:
**12.04.89 Bulletin 89/15**

(84) Etats contractants désignés:
**DE GB IT NL**

(56) Documents cités:
**EP-A- 0 043 943**
**EP-A- 0 090 520**
**EP-A- 0 115 131**
**JP-A-59 123 266**

**Patents Abstracts of Japan, vol. 8, no. 247 (E-278), 13 November 1984**

(73) Titulaire: **COMMISSARIAT A L'ENERGIE ATOMIQUE, 31/33, rue de la Fédération, F-75015 Paris (FR)**

(72) Inventeur: **JEUCH, Pierre, 13, rue du Parc, F-38170 Seyssins (FR)**

(74) Mandataire: **Mongrédien, André et al, c/o BREVATOME 25, rue de Ponthieu, F-75008 Paris (FR)**

ACTORUM AG

## Description

La présente invention a pour objet un procédé de fabrication d'un circuit intégré de type MIS (metal-isolant semiconducteur) et notamment de type MOS ou CMOS. Elle s'applique en particulier dans le domaine de l'électronique et de l'informatique pour la réalisation de portes logiques, de bascules, de mémoires mortes ou vives, etc...

Les circuits intégrés, notamment les circuits MOS ou CMOS, sont formés principalement de transistors à canal N et/ou à canal P reliés électriquement entre eux.

Dans ces circuits intégrés, il existe plusieurs couches conductrices, situées à des niveaux différents, assurant les interconnexions des transistors de ces circuits; la réalisation de ces différents niveaux de connexion nécessite d'avoir une structure de circuit la plus plane possible.

Les étapes des procédés de fabrication des circuits intégrés servant à obtenir des structures relativement planes sont généralement connues sous le nom d'étapes de «planarisation».

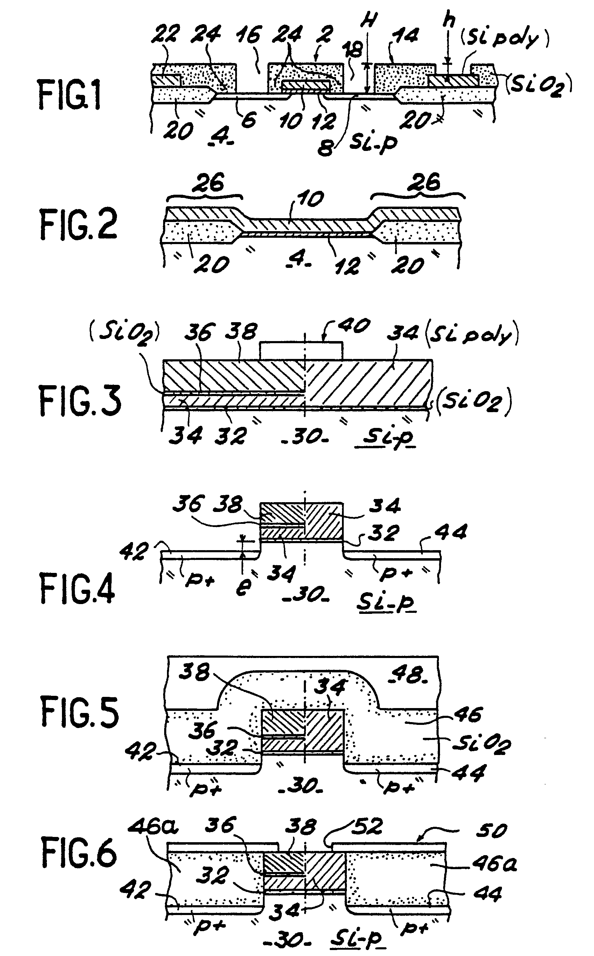

Malheuresement, l'emploi d'une telle technologie, dans les procédés classiques de fabrication des circuits intégrés, entraîne de grosses difficultés lors des prises de contact sur les sources et les drains des transistors constituant ces circuits. Cet inconvénient est illustré par la figure 1 annexée, représentant, en coupe longitudinale et schématiquement, une partie d'un circuit intégré MOS conformément à l'art antérieur.

Sur la figure 1, on a représenté un transistor 2 de type MOS, réalisé sur un substrat semi-conducteur 4, notamment en silicium polycristallin. Le transistor 2 comporte une source 6 et un drain 8, réalisés par implantation d'ions dans le substrat 4, et une grille 10, réalisée généralement en silicium polycristallin, surmontant un oxyde de grille 12 réalisé au-dessus du substrat 4, entre la source 6 et le drain 8. La zone active de ce transistor 2 est surmontée d'une couche isolante 14, généralement en oxyde de silicium, servant, entre autres, à isoler la grille 10 du transistor de la source 6 et du drain 8 de celui-ci. Dans cette couche isolante 14, sont réalisés des trous de contact électrique 16 et 18 permettant respectivement les prises de contact électrique sur la source 6 et le drain 8 du transistor.

Ce transistor 2 est isolé électriquement des autres composants et notamment des autres transistors constituant le circuit intégré par des zones d'oxyde de silicium 20, partiellement enterrées dans le substrat, constituant ce qu'on appelle l'oxyde de champ du circuit. Sur cet oxyde de champ, est généralement réalisé un premier niveau d'interconnexion 22, permettant de connecter entre eux une partie des transistors du circuit intégré.

La couche d'oxyde 14, dans laquelle sont réalisés les trous de contact 16 et 18 des source et drain, permet d'assurer aussi, une isolation électrique entre le premier niveau d'interconnexion 22 du circuit intégré et le suivant.

Afin d'assurer une bonne isolation électrique entre le premier niveau d'interconnexion 22 et le suivant, il est nécessaire que la couche isolante 14 comporte, entre ce premier niveau d'interconnexion et le suivant, une hauteur minimum h, typiquement de l'ordre de 0,7 µm. Cette hauteur h minimum entraîne, compte tenu de l'épaisseur de l'oxyde de champ 20 (voisin de 0,5 µm) et de la première ligne d'interconnexion 22, la réalisation des trous de contact électriques tels que 16 et 18 d'une profondeur H relativement élevée, typiquement de l'ordre de 1,4 µm.

La réalisation de trous de contact électriques relativement profonds pose de nombreux problèmes pour la prise de contact des sources et des drains tels l'apparition de cassure ou fissure dans la couche conductrice, déposée à l'intérieur des trous de contact servant à connecter entre eux les sources et/ou les drains des transistors, entraînant la réalisation de transistors et donc de circuits intégrés défectueux.

Comme on l'a dit précédemment, il est nécessaire de rendre la plus plane possible la surface des circuits intégrés, à chaque étape de leur fabrication de façon à faciliter la réalisation des différentes connexions de ces circuits.

Or, l'un des facteurs gênant la planéité des circuits intégrés est le recouvrement de l'oxyde de champ de ces circuits par l'électrode de grille des composants (transistors) desdits circuits. Ceci est illustré par la figure 2 qui représente, en coupe transversale, une partie du circuit intégré de la figure 1. Sur cette figure, les zones de recouvrement de la grille 10 du transistor MOS sur l'oxyde de champ 20 portent la référence 26.

En plus de ces problèmes, compte tenu de l'évolution des circuits intégrés et de leur intérêt grandissant pour la réalisation de circuits en électronique et/ou en informatique, on recherche de plus en plus à diminuer les dimensions des composants les constituant et notamment des transistors, c'est-à-dire à augmenter la densité d'intégration de ces circuits.

Or, l'un des facteurs limitant la densité d'intégration des circuits intégrés est la réalisation de trous de contact électriques tels que 16 et 18 dans la couche de matérau isolant 14 (figure 1). En effet, le positionnement correct de ces trous de contact en regard des régions de source 6 et de drain 8, réalisées dans le substrat 4, nécessite de prévoir dans la couche isolante 14 des gardes d'isolant telles que 24.

La présente invention a justement pour but la fabrication d'un circuit intégré notamment de type MOS ou CMOS permettant notamment de résoudre les problèmes donnés précédemment. Elle permet, en particulier des prises de contact aisées des sources et drains des transistors du circuit intégré, tout en permettant la réalisation de circuits intégrés ayant une structure pratiquement plane ainsi qu'une augmentation notable de la densité d'intégration de ces circuits.

La présente invention vise notamment à réaliser un circuit intégré comportant des composants actifs, et notamment des transistors MOS, isolés électriquement les uns des autres, dont les grilles ne s'étendent pas au-dessus des isolations électriques servant à isoler lesidts composants les uns des autres. Ceci permet d'améliorer la planéité des circuits intégrés et donc de faciliter la réalisation des connexions entre les différents composants desdits circuits intégrés.

De façon plus précise, l'invention a pour objet un premier procédé de fabrication selon la revendication 1 (première variante) ou selon la revendication 2 (seconde variante).

Ce premier procédé permet, grâce à l'ordre des étapes le constituant, d'augmenter la densité d'intégration des circuits intégrés et de faciliter la réalisation des différentes connexions de ces circuits. Par ailleurs, les différentes étapes de ce procédé sont non critiques, faciles à réaliser et reproductibles, ce qui n'est pas toujours le cas dans les procédés de l'art antérieur. Ce procédé peut donc être avantageusement utilisé pour la fabrication industrielle et en série des circuits intégrés et en particulier des circuits MOS ou CMOS.

Selon un mode préféré de mise en œuvre du premier procédé de l'invention, on réalise l'oxyde de champ du circuit intégré, c'est-à- dire des zones d'isolation, en effectuant, dans l'ordre, les étapes suivantes:

(1) définition des régions du substrat dans lesquelles seront réalisés les composants actifs, à l'aide d'un premier masque positif,

(2) élimination des régions des différentes couches de matériau surmontant le substrat, dépourvues dudit premier masque, de façon à mettre à nu certaines régions du substrat,

(3) réalisation d'un dopage du substrat dans les régions mises à nu de celui-ci, ce dopage ayant une conductivité du même type que celle du substrat,

(4) élimination dudit premier masque,

(5) dépôt d'une couche d'un troisième matériau isolant sur l'ensemble de la structure obtenue, et

(6) réalisation d'une gravure de la couche de troisième matériau de façon à mettre à nu la couche de matériau gravée se trouvant directement en-dessous de la couche de troisième matériau.

Par masque positif, il faut comprendre un masque définissant les régions qu'il couvre. En revanche, par masque négatif, il faut comprendre un masque définissant les régions qu'il ne couvre pas.

La réalisation de l'oxyde de champ du circuit intégré, telle que décrite ci-dessus, contribue fortement à augmenter la densité d'intégration de ce circuit. Par ailleurs, il permet, par rapport au procédé classique de fabrication de l'oxyde de champ appelé procédé LOCOS, d'éviter la réalisation d'un traitement thermique prolongé, étape fastidieuse et longue, entraînant une diffusion dans le substrat des ions implantés, nécessaires au dopage sous l'oxyde de champ.

La présente invention a aussi pour objet un second procédé de fabrication selon la revendication 6.

Ce second procédé permet, comme le premier, d'augmenter de façon notable la densité d'intégration des circuits intégrés et de faciliter la réalisation des différentes connexions de ces circuits.

Selon un mode préféré de mise en œuvre du second procédé de l'invention, on réalise l'oxyde de champ du circuit intégré en effectuant, dans l'ordre, les étapes suivantes:

- réalisation d'un deuxième dopage du substrat ayant une conductivité du même type que celle du substrat,

- dépôt d'une couche d'un troisième matériau isolant sur l'ensemble du substrat semiconducteur,

- définition des régions du substrat dans lesquelles seront réalisés les composants actifs à l'aide d'un premier masque négatif,

- élimination des régions de la couche de troisième matériau dépourvues dudit premier masque, et

- élimination dudit premier masque.

D'autres caractéristiques et avantages de l'invention ressortiront mieux de la description qui va suivre, donnée à titre illustratif et non limitatif en référence aux figures annexées, dans lesquelles:

- la figure 1, déjà décrite, représente schématiquement, en coupe longitudinale, un circuit intégré conformément à l'art antérieur,

- la figure 2, déjà décrite, représente schématiquement, en coupe transversale, une partie du circuit intégré de la figure 1,

- les figures 3 à 17 illustrent schématiquement, en coupe longitudinale, les différentes étapes du premier procédé de fabrication d'un circuit intégré conformément à l'invention, les figures 7a et 13a illustrant des variantes de ce premier procédé,

- les figures 18 à 20 illustrent schématiquement, en coupe longitudinale, une partie des différentes étapes du second procédé de fabrication d'un circuit intégré conformément à l'invention, et

- la figure 21 représente schématiquement, en coupe transversale, une partie d'un circuit intégré conformément à l'invention.

La description ci-dessous se rapporte à la fabrication d'un circuit intégré MOS comportant un seul transistor à canal N, de façon à simplifier cette description. Mais bien entendu, l'invention a une portée beaucoup plus générale puisqu'elle s'applique à tout circuit intégré de type MIS réalisés sur un substrat semiconducteur, ce dernier étant un substrat massif ou une couche semiconductrice surmontant un support isolant.

La transposition de la description ci-dessous à une technologie CMOS, comportant essentiellement des opérations supplémentaires de dopage, et notamment d'implantation ionique, est évidente pour l'homme du métier. Il en est de même pour la réalisation de transistors à canal P.

Par ailleurs, certaines étapes des procédés de l'invention, telles que des étapes de nettoyage, ne seront pas décrites par la suite, ces étapes étant aussi évidentes pour l'homme du métier.

En se référant aux figures 3 à 17, on va décrire un premier procédé de fabrication d'un circuit intégré conformément à l'invention.

Ce premier procédé consiste tout d'abord, comme représenté sur la figure 3, à recouvrir un substrat semiconducteur 30, notamment en silicium monocristallin de type p, d'une couche 32 d'un premier matériau isolant, réalisé de préférence en oxyde de silicium. Cette couche 32, présentant notamment une épaisseur de 0,025 μm, peut être obtenue par oxydation thermique du substrat en silicium 30, à une température voisine de 900 °C. Cette couche 32 d'oxyde de silicium constituera ultérieurement l'oxyde de grille du transistor MOS à canal N à réaliser.

A travers cette couche 32 d'oxyde de silicium, on réalise ensuite en dopage du substrat 30 servant à définir le dopage sous le canal du transistor, ce dopage ayant une conductivité du même type que celle du substrat 30. Ce dopage peut être obtenu par implantation ionique et notamment en implantant des ions de bore lorsque le substrat est de type p: une première implantation à une dose de $10^{12}$ at./$cm^2$ avec une énergie de 50 keV et une seconde implantation à une dose de $4 \cdot 10^{11}$ at./$cm^2$ avec une énergie de 140 keV.

L'étape suivante du premier procédé consiste à déposer sur la couche d'isolant 32 une couche 34 d'un second matériau, conducteur ou semiconducteur, dans laquelle sera réalisée ultérieurement la grille du transistor MOS à canal N. De préférence, cette couche 34 est réalisée en silicium polycristallin dopé ou non au phosphore, en siliciures de molybdène, tungstène, tantale ou titane ou en un métal réfractaire tel que le molybdène, le tantale, le titane et le tungstène. Le dépôt de cette couche 34 peut être obtenu par un procédé de dépôt chimique en phase vapeur (CVD ou LPCVD) ou par pulvérisation magnétron.

Dans une première variante du premier procédé, représentée sur la partie droite de la figure 3, la couche conductrice ou semiconductrice 34 est unique et elle présente une épaisseur d'environ 1,2 μm.

Dans une autre variante, représentée sur la partie gauche de la figure 3, cette couche conductrice 34 ne présente qu'une épaisseur d'environ 0,3 μm, et est recouverte successivement d'une couche 36, réalisée en un matériau isolant (dit sixième matériau), de préférence en oxyde de silicium, et d'une couche 38 réalisée en un matériau notamment conducteur ou semiconducteur (dit septième matériau).

La couche 36, ayant par exemple une épaisseur de 0,07 μm peut être obtenue par oxydation thermique de la couche 34 lorsque cette dernière est réalisée en silicium polycristallin ou en siliciures, à une température de l'ordre de 900 °C. Dans les autres cas, cette couche 36 peut être obtenue par dépôt et notamment par un procédé de dépôt chimique en phase vapeur (CVD ou LPCVD). Cette couche 36, servira ultérieurement de couche d'arrêt de gravure.

La couche 38 en matériau conducteur ou semiconducteur, surmontant la couche isolante 36 peut être réalisée comme la couche 34 et notamment en silicium polycristallin, en siliciures, en molybdène, en tantale, en titane et en tungstène.

Cette couche 38, présentant une épaisseur de 0,6 μm, peut être obtenue par un procédé de dépôt chimique en phase vapeur (CVD ou LPCVD). Cette couche 38 intervient principalement pour des raisons de topologie plutôt que pour ses propriétés physiques ou électriques.

Les étapes suivantes du premier procédé consistent à réaliser les isolations du circuit intégré constituées principalement par l'oxyde de champ dudit circuit.

On réalise tout d'abord, aussi bien dans le cas d'une couche conductrice 34 épaisse ou d'un empilement de couches 34, 36, et 38, par les procédé classiques de photolitographie, un masque de résine 40, dit positif, servant à définir la région du substrat 30 dans laquelle sera réalisé le transistor à canal N; ce masque est positif, car il masque ladite région du substrat 30 dans laquelle sera réalisé le transistor. Puis, comme représenté sur la figure 4, on élimine les régions des différentes couches du matériau surmontant le substrat 30, c'est-à-dire des couches 32 et 34 (première variante côté droit de la figure 4) ou des couches 32, 34, 36 et 38 (deuxième variante côté gauche de la figure 4), dépourvues du masque 40 jusqu'à mise à nu des régions du substrat 30 non recouvertes dudit masque.

Cette élimination peut être réalisée par des gravures anisotropes, et notamment des gravures ioniques réactives, successives des différentes couches de matériau surmontant le substrat semiconducteur. Les couches isolantes, notamment en oxyde de silicium, 32 et 36 peuvent être gravées avec du trifluorométhane ($CHF_3$) et les couches conductrices 34 et 38, lorsque celles-ci sont réalisées en silicium polycristallin ou en siliciures par de l'hexafluorure de soufre ($SF_6$).

Le fait d'utiliser des agents d'attaque différents suivant que les couches sont isolantes (couches 32 et 36) ou bien conductrices ou semiconductrices (couches 34 et 38), permet d'utiliser la couche située en-dessous de celle que l'on grave comme couche d'arrêt de gravure, ce qui permet de compenser les inhomogénéités d'épaisseur de ces différentes couches.

Eventuellement, comme représenté sur la figure 4, on réalise ensuite une gravure des régions du substrat mises à nu sur une épaisseur e, en utilisant le masque 40 comme masque à cette gravure. Cette gravure du substrat permettra d'obtenir ultérieurement un oxyde de champ partiellement enterré, comme dans les procédés classiques de fabrication de cet oxyde. L'épaisseur de gravure e est par exemple voisine de 0,4 μm. La gravure du substrat 30 ou plutôt de ses régions mises à nu, est réalisée de préférence de façon anisotrope en utilisant par exemple une gravure ionique réactive avec de l'hexafluorure de soufre comme agent d'attaque pour un substrat en silicium.

L'étape suivante de réalisation de l'oxyde de champ conformément à l'invention consiste, en utilisant toujours le même masque de résine 40, à réaliser un dopage du substrat 30, ou plutôt des régions mises à nu de celui-ci, ce dopage ayant une conductivité du même type que celle du substrat. Ce dopage peut par exemple être réalisé par implantation ionique en implantant notamment des ions de bore, dans le cas d'un substrat de type p, à une énergie de 80 keV et à une dose de $10^{12}$ at./cm². Ce dopage permet d'obtenir deux régions latérales 42 et 44 notamment de type p⁺.

Après ce dopage, on élimine le masque 40 de résine par exemple par attaque à l'aide d'un plasma d'oxygène.

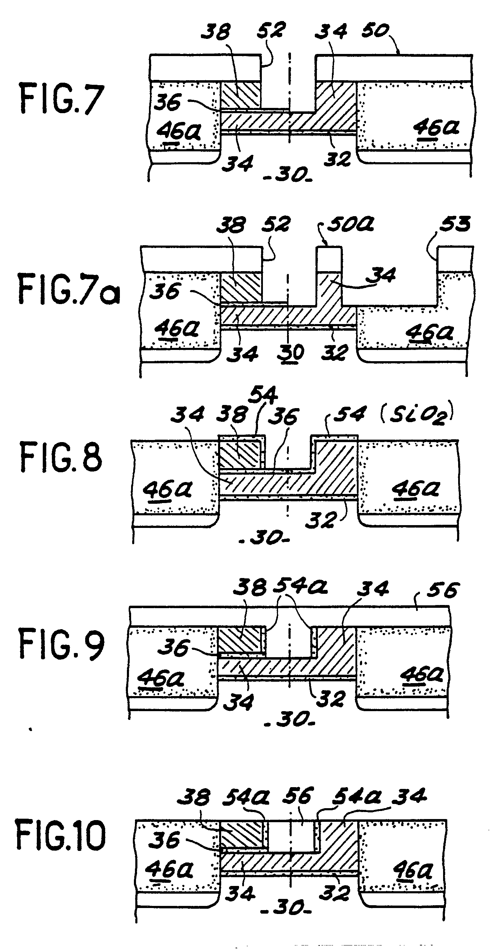

Comme représenté sur la figure 5, on dépose, ensuite, sur l'ensemble de la structure une couche 46 d'un matériau isolant (dit troisième matériau) réalisé par exemple en oxyde de silicium éventuellement dopé au phosphore. Cette couche d'isolant 46 représente par exemple une épaisseur de 1,5 µm. Elle peut être obtenue par un procédé de dépôt chimique en phase vapeur à basse pression (LPCVD) et de préférence avec assistance par plasma (PECVD).

Cette couche d'isolant 46 peut ensuite être avantageusement soumise à un traitement thermique, par exemple à une température de 1050 °C pendant 10 mn de façon à densifier ladite couche 46.

La dernière étape servant à obtenir l'oxyde de champ du circuit intégré conformément à l'invention, consiste à réaliser une gravure de la couche 46, notamment en oxyde de silicium, de façon à mettre à nu la couche de matériau gravée se trouvant directement en-dessous de ladite couche 46.

Dans la variante représentée sur la partie gauche de la figure 5, la gravure de la couche isolante 46 va permettre de mettre à nu la couche conductrice ou semiconductrice 38 et dans la variante représentée sur la partie droite de la même figure, la gravure de cette couche 46 va permettre de mettre à nu la couche conductrice ou semiconductrice 34 épaisse.

La gravure de la couche isolante 46 est réalisée de façon avantageuse (selon la technologie de planarisation) en déposant sur ladite couche, de façon connue, une couche 48 d'un matériau isolant (dit quatrième matériau) effaçant le relief de la couche 46. La couche isolante 48 est de préférence réalisée en résine telle que celle couramment utilisée en photolithographie. Le dépôt de cette couche de résine 48, présentant notamment une épaisseur de 1,5 µm, peut être suivi d'un traitement thermique, par exemple un chauffage à une température de l'ordre de 200 °C pendant une 1/2 heure, de façon à obtenir un bon étalement de cette couche de résine 48 et donc une bonne surface plane.

On réalise ensuite une gravure simultanée de la couche de résine 48 et de la couche d'isolant 46 notamment en oxyde de silicium, à des vitesses d'attaque identiques pour la résine et l'oxyde jusqu'à élimination totale, comme représenté sur la figure 6, de la région de la couche 46 surmontant soit la couche conductrice ou semiconductrice 38 gravée (à gauche de la figure) soit la couche conductrice ou semiconductrice 34 gravée (à droite de la figure). Cette gravure entraînant l'obtention d'un oxyde de champ 46a de surface parfaitement plane est réalisée de préférence de façon anisotrope par exemple par un procédé de gravure ionique réactife utilisant comme agent d'attaque un mélange de tri ou tétrafluorométhane ($CHF_3$ ou $CF_4$) et d'oxygène: les composés fluorés servant à la gravure de l'oxyde de silicium et l'oxygène à la gravure de la résine.

Les étapes suivantes du premier procédé de fabrication d'un circuit intégré conformément à l'invention concernent la réalisation des grilles des composants actifs dudit circuit, et dans le cas présent la grille du transistor MOS à canal N.

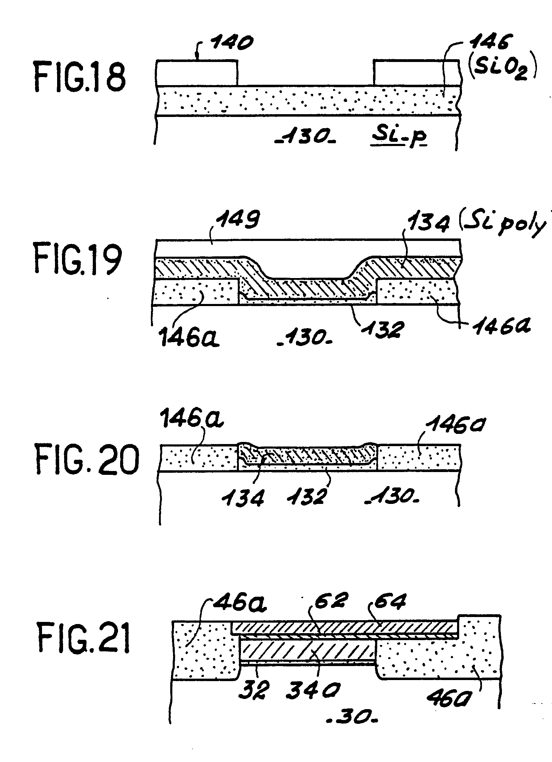

La réalisation de la grille de ce transistor consiste tout d'abord, comme représenté surla figure 6, à définir les dimensions de la grille et des connexions électriques de ladite grille à l'aide d'un masque négatif 50 notamment en résine disposé au-dessus de la structure. La largeur de l'ouverture 52 de ce masque dit négatif correspondent exactement à celle de la grille du transistor à réaliser. Par ailleurs, l'ouverture 52 du masque 50 déborde sur l'oxyde de champ 46a de façon à pouvoir réaliser une connexion de cette grille. Ceci apparaît sur la figure 21, représentant, en coupe transversale, une partie d'un circuit intégré conformément à l'invention. Le débordement des couches conductrices 62 et 64 sur l'oxyde de champ 46a correspond au débordement de l'ouverture 52 sur l'oxyde de champ et donc à la connexion de la grille.

Dans une première variante, représentée sur la partie droite de la figure 7, on réalise, à l'aide du masque 50, une première gravure de la couche conductrice ou semiconductrice 34 sur une hauteur d'environ 0,6 µm. Cette gravure peut être réalisée de façon anisotrope par exemple par un procédé de gravure ionique réactive en utilisant comme agent d'attaque de l'hexafluorure de soufre lorsque cette couche est réalisée en silicium polycristallin. Le contrôle de fin de gravure peut être fait par tout moyen connu.

Dans une seconde variante, représentée sur la partie gauche de la figure 7, correspondant à l'utilisation d'une couche conductrice ou semiconductrice 34 de plus faible épaisseur recouverte successivement d'une couche isolante 36 et d'une couche conductrice ou semiconductrice 38, on réalise à l'aide du masque négatif 50 une gravure de la couche 38 de façon à éliminer de cette couche les régions non recouvertes par le masque 50 et à mettre à nu les régions de la couche isolante 36 sous-jacentes. Cette gravure peut être réalisée par une gravure ionique réactive utilisant comme agent d'attaque de l'hexafluorure de soufre pour une couche 38 en silicium polycristallin.

Ce masque peut éventuellement servir à définir, en plus de celles de la grille et des connexions de ladite grille, les dimensions des connexions à courte distance à réaliser entre la source et/ou le drain du transistor du circuit intégré avec une source et/ou un drain d'un autre transistor de ce même circuit. Par exemple, ce masque portant la référence 50a, comme représenté sur la figure 7a, peut être muni d'une ouverture 53 dont les dimensions correspondent à celles d'une connexion à réaliser, par exemple une connexion du drain du transistor.

Cette ouverture 53 débordera légèrement au-dessus de la région du transistor à réaliser pour tenir compte des tolérances de positionnement entre ce masque 50a et le masque 40 (figure 3).

Après avoir gravé la couche conductrice semiconductrice 34 (partie droite de la figure) ou la couche conductrice ou semiconductrice 38 (partie gauche de la figure), on réalise une gravure dans l'oxyde de champ 46a, à l'aide du masque 50 ou 50a, sur une hauteur de l'ordre de 0,6 µm. Cette gravure peut être réalisée de façon anisotrope par un procédé de gravure ionique réactive avec comme agent d'attaque du trifluorométhane.

Après élimination du masque 50 ou 50a notamment en résine, à l'aide d'un plasma d'oxygène, on recouvre éventuellement la structure, comme représenté sur la figure 8, d'une couche 54 d'un matériau isolant (dit neuvième matériau) par exemple en oxyde de silicium. Dans le cas d'une couche 34 (partie droite de la figure) ou d'une couche 38 (partie gauche de la figure) en silicium polycristallin ou en siliciure, cette couche isolante 54 peut être obtenue par oxydation thermique, à une température d'environ 900 °C, du silicium ou du siliciure. Cette couche 54 présente une épaisseur de l'ordre de 0,1 µm.

On réalise ensuite une gravure de la couche d'isolant 54 de façon à ne laisser, comme représenté sur la figure 9, de cette couche 54 que les bandes verticales 54a sur les flancs gravés de la couche conductrice ou semiconductrice 34 ou 38 suivant la variante utilisée, les régions horizontales de cette couche étant éliminées. Par ailleurs, cette gravure de la couche isolante 54 permet d'éliminer les régions de la couche isolante 36 mises à nu, lors de la gravure de la couche 38 en utilisant le masque 50 ou 50a définissant les dimensions de la grille du transistor, dans le cas de la variante du procédé utilisant ces deux couches 36 et 38. Cette gravure peut être réalisée de façon anisotrope par un procédé de gravure ionique réactive utilisant du trifluorométhane comme agent d'attaque, pour une couche 54 en oxyde de silicium.

La réalisation de la grille du transistor se poursuit en déposant sur l'ensemble de la structure une couche 56 d'un matériau isolant (dit huitième matériau) servant à effacer le relief de la structure. Cette couche 56 est de préférence réalisée en polyimide. Après dépôt de cette couche de polyimide, celle-ci peut être soumise à un traitement thermique tel qu'un chauffage à une température de l'ordre de 400 °C pendant une 1/2 heure de façon à obtenir un bon étalement de cette couche 56 et donc une surface plane ainsi qu'un bon durcissement (réticulation) du polyimide.

Ensuite, on réalise une gravure de cette couche d'isolant 56, de préférence en polyimide, de façon à ne garder de cette couche 56 que les parties remplissant les régions en creux de la structure de façon à obtenir, après la gravure de cette couche 56, une structure parfaitement plane, comme représentée sur la figure 10.

Les parties en creux correspondent à la région gravée de la couche 34 ou 38 et éventuellement à celle de l'oxyde de champ 46a (figure 7a), lorsque l'on définit les connexions à courte distance du circuit intégré en même temps que celles de la grille du transistor.

La gravure de la couche d'isolant 56 peut être réalisée, lorsque celle-ci est en polyimide, par un procédé de gravure ionique réactive en utilisant de l'oxygène comme agent d'attaque.

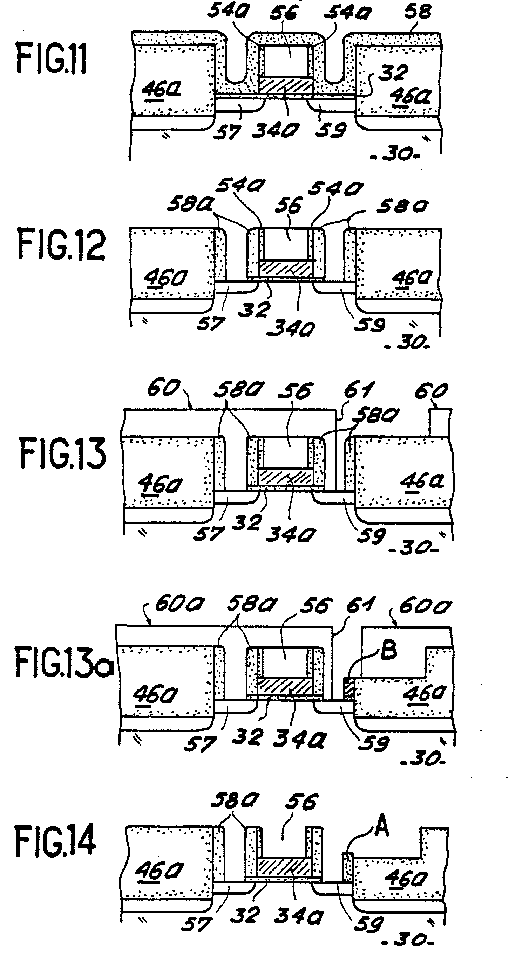

Dans le cas d'une couche conductrice ou semiconductrice 34 d'épaisseur importante, on réalise ensuite, comme représenté sur la partie droite de la figure 11, une gravure de cette couche 34 de façon à éliminer des régions de celle-ci non recouvertes par la couche 56 de matériau isolant restante. Cette gravure est réalisée de façon à mettre à nu la couche isolante 32, sous-jacente. Elle peut être effectuée par un procédé de gravure anisotrope et notamment par un procédé de gravure ionique réactive utilisant de l'hexafluorure de soufre comme agent d'attaque lorsque la couche 34 est en silicium polycristallin.

Dans la variante d'une couche 34 conductrice ou semiconductrice mince recouverte d'une couche isolante 36 et d'une couche conductrice ou semiconductrice 38 on élimine, comme représenté sur la partie gauche de la figure 11, ce qui reste de la couche 38, puis on réalise une gravure de la couche isolante 36 et de la couche conductrice ou semiconductrice 34 jusqu'à mise à nu de la couche isolante 32, la couche 56 gravée servant de masque à cette gravure; ces gravures sont réalisées en utilisant le restant de la couche 56 comme masque.

De préférence, ces gravures sont réalisées de façon anisotrope par des procédés de gravure ionique réactive en utilisant comme agent d'attaque de l'hexafluorure de soufre pour les couches conductrices 38, 34 réalisées en silicium polycristallin et du tétrafluorométhane pour la couche conductrice 36 réalisée en oxyde de silicium. Comme précédemment, le changement de produit d'attaque pour les gravures permet d'utiliser la couche sous-jacente à celle que l'on grave comme couche d'arrêt de gravure, ce qui permet ainsi de compenser les inhomogénéités des différentes couches.

L'utilisation d'une couche isolante 36 intercalée entre deux couches conductrices ou semiconductrices 34 et 38 permet d'améliorer et de faciliter les différentes gravures de ces couches par rapport à l'utilisation d'une couche unique épaisse 34 et donc facilite la réalisation de la grille du transistor. Cette grille ainsi réalisée porte la référence 34a.

L'étape suivante du premier procédé de fabrication d'un circuit intégré conformément à l'invention consiste à réaliser la source et le drain du transistor MOS à canal N de ce circuit. Cette source et ce drain, portant respectivement les références 57 et 59, sont obtenus en effectuant un dopage du substrat 30 ayant une conductivité de type inverse de celle du substrat. Par exemple, dans le cas d'un substrat en silicium de type p, le dopage peut être réalisé par implantation ionique en implantant des ions d'arsenic notamment à une dose de $5 \cdot 10^{15}$ at./cm² avec une énergie de 100 keV. Cette implantation ionique est réalisée à travers la couche d'isolant 32, notamment en oxyde de silicium constituant l'oxyde de grille.

Les étapes suivantes du premier procédé de fabrication selon l'invention concernent la réalisation de bords isolants sur les flancs de la grille 34a du transistor MOS de ce circuit.

Pour cela, on réalise tout d'abord le dépôt sur l'ensemble de la structure d'une couche 58 d'un matériau isolant (dit dixième matériau) notamment en oxyde de silicium. Cette couche isolante 58, présentant par exemple une épaisseur de 0,3 μm, est déposée de façon isotrope par exemple au moyen d'un procédé de dépôt chimique en phase vapeur à basse pression assisté par un plasma (PECVD) et ce, à basse température par exemple voisine de 350 °C.

On réalise ensuite, comme représenté sur la figure 12, une gravure de cette couche d'isolant 58 de façon à ne laisser de cette couche 58 que les bandes isolantes 58a sur les flancs gravés de la structure. Les flancs gravés de la structure sont notamment les flancs de la grille 34a, les flancs isolants 54a et les flancs de l'oxyde de champ 46a. Les bandes isolantes 58a peuvent être réalisées avantageusement en gravant de façon anisotrope la couche 58, en utilisant notamment un procédé de gravure ionique réactive. En effet, ce type de gravure permet d'obtenir des bandes isolantes 58a dont la largeur est définie par l'épaisseur de la couche isolante 58 déposée de façon isotrope. En particulier, une couche 58 de 0,3 μm d'épaisseur permet d'obtenir des bandes isolantes 58a de 0,3 μm de large. Dans le cas d'une couche 58 en oxyde de silicium, celle-ci peut être gravée en utilisant comme agent d'attaque du trifluorométhane.

La gravure de la couche 58 permet aussi d'éliminer les régions de la couche d'isolant 32 situées au-dessus de la source 57 et du drain 59 du transistor, comme représenté sur la figure 12.

La réalisation précédemment décrite de bandes isolantes 54a surmontant la grille 34a du transistor permet d'améliorer la tenue du restant de la couche d'isolant 56 notamment en résine, et donc le profil des bandes isolantes 58a.

L'étape suivante du premier procédé selon l'invention consiste, comme représenté sur la figure 13, à réaliser sur l'ensemble de la structure un masque négatif 60, notamment en résine représentant l'image des connexions à courte distance entre la source 57 et/ou le drain 59 du transistor du circuit intégré avec une source et/ou un drain d'un autre transistor du même circuit intégré, au cas où les dimensions des connexions à réaliser du transistor n'ont pas été définies en même temps que celles de la grille du transistor et celles des connexions de ladite grille (figure 7a). Autrement dit, ce masque 60 permet de définir les dimensions de ces connexions. Dans le cas représenté sur la figure 13 le masque 60 permet, grâce à son ouverture 61 débordant au-dessus du drain 59, de définir les dimensions d'une connexion de ce drain à réaliser.

A l'aide de ce masque 60, on réalise ensuite (figure 14), une gravure de l'oxyde de champ 46a sur une hauteur de 0,6 μm ainsi qu'une gravure des bandes isolantes 58a non recouvertes par le masque 60, et dans le cas particulier uniquement la bande isolante se trouvant dans l'ouverture du masque 61. La gravure des bandes isolantes est effectuée approximativement à la même vitesse que celle de l'oxyde de champ 46a. Après cette gravure, il ne reste qu'une partie A de la bande 58a se trouvant dans l'ouverture 61 du masque 60 dont la hauteur est égale à celle de la différence de niveau entre le drain 59 et le fond de la gravure de l'oxyde de champ 46a. La gravure de la couche isolante 46, dans laquelle est réalisé l'oxyde de champ, et la gravure des bandes isolantes 58a en oxyde de silicium sont effectuées de préférence de façon anisotrope par un procédé de gravure ionique réactive utilisant comme agent d'attaque du trifluorométhane.

Lorsque les dimensions des connexions du transistor à courte distance des sources et drains à réaliser ont été définies en même temps que celles de la grille de ce dernier et des connexions de ladite grille (figure 7a), on utilise, alors, un masque 60a négatif notamment en résine, comme représenté sur la figure 13a, représentant alors uniquement l'image des contacts électriques à réaliser de la source 57 et/ou du drain 59 du transistor. A l'aide de ce masque 60a définissant en fait les dimensions de ces contacts et dans le cas présent uniquement celles du contact du drain 59, on réalise l'élimination des bandes isolantes 58a se trouvant de part et d'autre des connexions à réaliser et dans le cas particulier uniquement les bandes 58a situées du côté du drain 59, tout en gardant celles se trouvant de part et d'autre de la grille 34a du transistor. Cette élimination peut par exemple être effectuée par attaque chimique en utilisant par exemple de l'acide fluorhydrique lorsque ces bandes isolantes sont réalisées en oxyde de silicium.

Sur la figure 13a l'élément référencé B correspond à un résidu de la couche 34 résultant de la gravure d'une partie de cette couche lors de la gravure de l'oxyde de champ 46a (figure 7a).

L'étape suivante du premier procédé consiste, comme représenté sur la figure 14, à éliminer le masque 60 ou le masque 60a, notamment en utilisant un plasma d'oxygène, puis à éliminer le restant de la couche d'isolant 56 notamment en résine dans la même étape.

Après élimination du masque 60 ou 60a et du restant de la couche d'isolant 56, on effectue de façon avantageuse dans la source 57 et le drain 59 du transistor un nouveau dopage, ce dopage ayant une conductivité de type inverse de celle du substrat 30. Ce dopage réalisé notamment par implantation ionique permet d'obtenir au niveau de la grille 34a du transistor une double jonction de source et de drain, ce qui permet de diminuer le champ électrique entre le drain et la grille de ce transistor. Ce dopage peut être réalisé, dans le cas d'un substrat du type p, en implantant des ions d'arsenic avec une énergie de 130 keV et une dose de $5 \cdot 10^{15}$ at./cm$^2$.

L'étape suivante du procédé consiste à réaliser un recuit de l'ensemble de la structure obtenue de façon à rendre électriquement actifs les ions implantés en particulier lors de la réalisation de la source 57 et du drain 59 du transistor et à réarranger le réseau cristallin du substrat, perturbé lors des implantations. Ce recuit peut être réalisé dans un four à une température de l'ordre de 900 °C pendant environ 30 minutes.

L'étape suivante du procédé consiste à éliminer l'oxyde de silicium pouvant s'être formé lors de l'élimination du masque 60 et du restant de la couche d'isolant 56, compte tenu de l'agent d'attaque utilisé, c'est-à-dire plasma d'oxygène lorsque le masque 60 et la couche 56 sont réalisés en résine. Cette élimination peut être obtenue par un procédé de gravure ionique réactive en utilisant un mélange trifluorométhane et d'oxygène avec une concentration de 5% en volume d'oxygène.

Les étapes suivantes du premier procédé ont trait à la réalisation des contacts électriques et des connexions à courte distance du circuit intégré, c'est-à-dire des connexions entre les sources et/ou les drains des transistors du circuit.

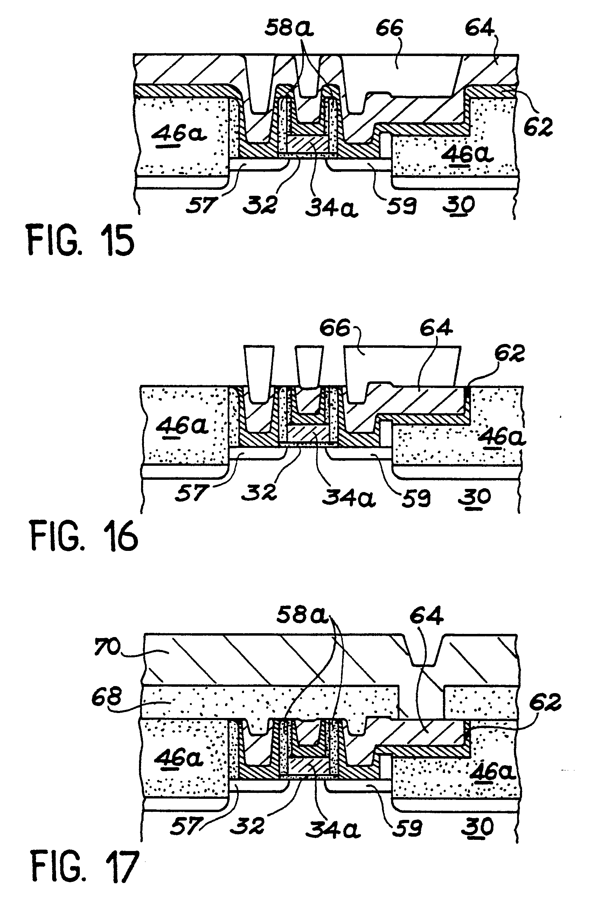

On réalise tout d'abord, comme représenté sur la figure 15, le dépôt d'une couche 62 d'un matériau conducteur ou semiconducteur (dit onzième matériau) puis éventuellement le dépôt d'une couche 64 d'un autre matériau conducteur ou semiconducteur. La couche 62 sert de barrière de diffusion à la couche 64 pour éviter que cette dernière ne réagisse avec le substrat 30 ou la grille 34a. La couche 62 présente par exemple une épaisseur de 0,1 µm et la couche 64 une épaisseur de 0,3 µm. Ces couches peuvent être réalisées en n'importe quel matériau généralement utilisé dans la fabrication des circuits intégrés. En particulier, elles peuvent être réalisées en siliciure ou en métal réfractaire (molybdène, platine, tantale, titane et tungstène) mais aussi en d'autres matériaux moins usuels tels que le cuivre, l'argent, etc..

De préférence, la couche 62 sera réalisée en un alliage de titane et de tungstène et la couche en aluminium. Le dépôt de la couche 62 et celui de la couche 64 peuvent être réalisés par un procédé de pulvérisation magnétron.

Ces couches 62 et 64 serviront aussi à réaliser la résistance de shunt de la grille 34a du transistor. Le fait de réaliser ces couches 62 et 64 respectivement en un alliage de titane et de tungstène et en aluminium, permet d'obtenir une résistance de shunt dix fois plus faible que dans les procédés de l'art antérieur, ce qui permet d'augmenter la rapidité de fonctionnement du transistor et donc du circuit intégré.

On réalise ensuite, sur la couche conductrice ou semiconductrice 64 le dépôt d'une couche 66 en matériau isolant (dit douzième matériau) permettant d'effacer le relief de la couche 64. De préférence, cette couche d'isolant 66 est réalisée en résine telle que celles couramment utilisées en photolithographie. Après son dépôt la couche de résine 66 peut être soumise à un traitement thermique, par exemple à une cuisson de l'ordre de 200 °C, de façon à obtenir un bon étalement de celle-ci et donc une surface plane.

On réalise ensuite une gravure de la couche d'isolant 66 afin de ne garder de l'isolant que dans les parties en creux du relief; la structure résultante, après cette gravure de la couche 66, présente alors une surface plane, comme représenté sur la figure 15. Cette gravure est réalisée de préférence par un procédé de gravure ionique réactive utilisant comme agent d'attaque de l'oxygène lorsque la couche 66 est réalisée en résine.

L'étape suivante du premier procédé consiste, comme représenté sur la figure 16, à éliminer les régions de la couche 64 puis celles de la couche 62 non recouvertes du restant de la couche isolante 66. Cette élimination peut être effectuée au moyen d'une gravure anisotrope telle qu'une gravure ionique réactive utilisant comme agent d'attaque du tétrafluorure de carbone pour une couche 64 réalisée en aluminium et de l'hexafluorure de soufre pour une couche 62 réalisée en un alliage de titane et de tungstène.

On élimine ensuite le restant de la couche 66 en utilisant par exemple un plasma d'oxygène. La structure obtenue est représentée sur la figure 17.

Les étapes précédentes, concernant la définition et la réalisation des contacts électriques et des connexions à courte distance du circuit intégré, permettent un autopositionnement ou autoalignement des contacts de la source et du drain du transistor par rapport à la grille de celui-ci. Par ailleurs, elles permettent d'augmenter de façon considérable la densité d'intégration des circuits intégrés, par rapport à l'art antérieur, par suppression de la couche de matériau isolant notamment en oxyde de silicium dans laquelle on réalise les trous de contact électriques des sources, des drains et des grilles des composants en gravant ladite couche (couche 14 figure 1).

Les étapes suivantes du premier procédé consistent à réaliser les connexions à grandes distances entre les différents composants du circuit intégré. Ces connexions sont réalisées de façon classique, comme représenté sur la figure 17, en déposant une couche d'isolant 68, notamment en oxyde de silicium, en effectuant les différents trous de contact électriques dans cette couche d'isolant, en déposant une couche conductrice 70 notamment en aluminium sur l'ensemble de la structure puis en gravant cette couche au moyen d'un masque approprié, de façon à réaliser les différentes connexions.

Les trous de contact électriques seront réalisés de préférence au-dessus de régions d'oxyde de champ 46a pour avoir une profondeur de trou unique.

Etant donné la quasi-planéité de la structure obtenue grâce au procédé de fabrication du circuit intégré de l'invention (figure 17), la réalisation de ces connexions à grandes distances se trouve nettement facilitée par rapport aux procédés de l'art antérieur.

Sur les figures 18 à 20, on a représenté schématiquement, en coupe longitudinale, les différentes étapes d'un second procédé de fabrication d'un circuit intégré conformément à l'invention. Comme précédemment, la description qui va suivre se rapporte à la fabrication d'un circuit intégré MOS comportant un seul transistor à canal N de façon à simplifier cette description.

Les couches de matériau ayant le même rôle que celles décrites précédemment pour le premier procédé de fabrication porteront les mêmes références additionnées du chiffre 100.

La première étape de ce second procédé consiste à réaliser, dans un substrat semiconducteur 130, notamment en silicium monocristallin de type p, un dopage ayant une conductivité de même type que celle du substrat. Ce dopage permet de définir simultanément le dopage sous le canal du transistor ainsi que le dopage de l'oxyde de champ du circuit intégré à réaliser. Un tel système de dopage a notamment été décrit dans un article de IEEE Transaction on Electron Devices vol. ED 29, n°4, d'avril 1982 de K.L. WANG et al. intitulé «Direct moat isolation for VLSI».

De préférence, ce dopage est réalisé par implantation ionique en implantant notamment des ions de bore, dans le cas d'un substrat de type p, à une dose de $5,3 \cdot 10^{11}$ at./cm$^2$ avec une énergie de 80 keV, suivie d'une autre implantation à une dose de $3,2 \cdot 10^{11}$ at./cm$^2$ avec une énergie de 150 keV.

L'étape suivante de ce second procédé consiste à recouvrir le substrat semiconducteur 130 d'une couche de matériau isolant 146, de préférence en oxyde de silicium, dans laquelle sera réalisé ultérieurement l'oxyde de champ du circuit intégré. Cette couche 146 peut être obtenue par dépôt et notamment par un procédé de dépôt chimique en phase vapeur à basse pression (LPCVD) avec de préférence assistance par plasma (PECVD). Cette couche isolante 146 présente par exemple une épaisseur de 1 µm.

Sur cette couche d'isolant 146, on réalise un masque 140 dit négatif, notamment en résine, par les procédés classiques de la photolithographie. Ce masque négatif 140 permet de définir la région du substrat dans laquelle sera réalisé ultérieurement le transistor à canal N du circuit intégré.

On réalise ensuite, comme représenté sur la figure 19, une gravure de la couche 146 d'isolant de façon à éliminer de cette couche les régions non recouvertes du masque 140. Cette gravure peut être réalisée de façon anisotrope et notamment par un procédé de gravure ionique réactive en utilisant comme agent d'attaque du trifluorométhane lorsque la couche 146 est réalisée en oxyde de silicium. L'oxyde de champ ainsi réalisé porte la référence 146a.

L'étape suivante de ce second procédé consiste à éliminer le masque de résine 140 notamment à l'aide d'un plasma d'oxygène.

On effectue ensuite le recouvrement des régions du substrat mises à nu par une couche 132 de matériau isolant notamment en oxyde de silicium. Cette couche 132 peut par exemple être obtenue par une oxydation thermique du substrat à une température de l'ordre de 900 °C. Cette couche 132 présente notamment une épaisseur de 0,025 µm. Cette couche d'oxyde 132 constituera ultérieurement l'oxyde de grille du transistor.

Sur l'ensemble de la structure, on réalise ensuite le dépôt d'une couche 134 d'un matériau conducteur ou semiconducteur dans laquelle sera réalisée ultérieurement la grille du transistor. Le dépôt de cette couche 134 peut être réalisé par un procédé de dépôt chimique en phase vapeur. Cette couche 134 présentant par exemple une épaisseur de 1,2 µm peut être réalisée en silicium polycristallin dopé au phosphore ou non, en siliciure ou en un métal réfractaire tel que le molybdène, le tantale, le titane et le tungstène.

L'étape suivante du second procédé consiste à réaliser une gravure de cette couche 134 de façon à mettre à nu l'oxyde de champ 146a. Ceci peut être réalisé, comme représenté sur la figure 19, en déposant sur la couche 134 conductrice ou semiconductrice une couche 149 d'un matériau isolant servant à effacer le relief de la couche 134. Cette couche 149 est réalisée de préférence en résine telle que celle couramment utilisée en photolithographie. Après son dépôt, cette couche 149 peut être soumise à un traitement thermique permettant un bon étalement de celle-ci.

Ensuite, on grave simultanément la couche conductrice ou semiconductrice 134 et la couche d'isolant 149 avec des vitesses d'attaque identiques pour l'isolant et le matériau conducteur ou semiconducteur Dans le cas d'une couche 134 réalisée en silicium polycristallin et une couche 149 réalisée en résine, cette gravure peut être réalisée par un procédé de gravure ionique réactive utilisant comme agent d'attaque de l'hexafluorure de soufre et de l'oxygène, l'hexafluorure de soufre servant à attaquer le silicium polycristallin et l'oxygène la résine.

La structure obtenue après la gravure de la couche conductrice ou semiconductrice 134 est représentée sur la figure 20.

Les étapes suivantes de ce second procédé consistent à réaliser, comme précédemment, la grille du transistor (figures 6 à 11), la source et le drain de ce transistor (figure 12) ainsi que les différents contacts et connexions électriques de ce circuit (figures 13 à 17).

Il est à noter que ce second procédé est un peu plus critique que le premier procédé, en particulier à cause de l'absence de la couche d'isolant 36, servant de couche d'arrêt pour les étapes de gravure de la couche conductrice ou semiconductrice 38 et de la nécessité de réaliser le dopage de l'oxyde de champ et du canal du transistor en une même étape et de façon identique.

Les deux procédés de fabrication d'un circuit intégré décrits précédemment sont composés de plusieurs étapes s'enchaînant de façon très différente de celles des procédés actuellement connus. Ces deux procédés permettent d'obtenir un circuit intégré tel que représenté en coupe transversale, sur la figure 21.

Ce circuit intégré comporte une grille 34a entourée par l'oxyde de champ 46a du circuit intégré et ne s'étendant pas au-dessus de cet oxyde de champ, c'est-à-dire au-dessus des isolations électriques du circuit. Sur cette figure, la couche référencée 32 constitue, comme ci-dessus, l'oxyde de grille et les couches 62 et 64 les lignes conductrices définissant la résistance de shunt de la grille ainsi que les connexions de la grille 34a. De préférence, la couche 62 est réalisée en un alliage de titane et de tungstène et la couche 64 en aluminium, ce qui confère à la résistance de shunt une valeur dix fois plus faible que celle de l'art antérieur, compte tenu des bonnes propriétés électriques de ces matériaux.

Le fait que la grille 34a ne s'étende pas au-dessus de l'oxyde de champ 46a du circuit intégré fait que ce dernier présente une structure quasi-plane qui facilite de façon notable la réalisation des connexions de ce transistor aux autres composants du circuit intégré.

Les modes de mise en œuvre des procédés conformes à l'invention décrits précédemment n'ont été donnés qu'à titre d'exemple, certaines modifications dans les différentes étapes de ces procédés peuvent intervenir sans pour autant sortie du cadre de l'invention.

En particulier, l'élimination de la couche d'isolant 56, notamment en résine, pourrait être réalisée avant le dépôt de la couche d'isolant 58 servant à réaliser les flancs gravés 58a (figures 11 et 12). De même, la gravure de l'oxyde de champ 46a (figure 7a) lors de la définition des dimensions des connexions du transistor en même temps que celles de la grille du transistor peut être réalisée avant de graver la couche conductrice 38 ou 34.

De même, encore, le recuit servant à rendre électriquement actifs les ions implantés pour définir la source 57 et le drain 59 du transistor peut être réalisé juste après cette implantation et en particulier dans le cas où cette implantation ionique ne serait pas suivie d'autres implantations.

Par ailleurs, les différentes couches de matériau utilisées dans les procédés conformes à l'invention peuvent être obtenues d'une autre façon que celle décrite. En particulier, pour les couches d'isolant se trouvant au-dessus d'une couche conductrice ou semiconductrice réalisée notamment en silicium polycristallin, ces couches peuvent être obtenues par oxydation thermique du substrat lorsqu'elles sont obtenues par dépôt et inversement être obtenues par dépôt lorsqu'elles sont obtenues par oxydation.

Par ailleurs, le dépôt de la couche d'oxyde 46 dans laquelle sera réalisé l'oxyde de champ 46a peut être précédé par une oxydation thermique pour assurer une bonne interface avec le silicium constituant le substrat ainsi que les couches 34 ou 38.

De même, les gravures des différentes couches utilisées dans les procédés de l'invention, réalisées de façon anisotrope, peuvent être faites en utilisant des procédés de gravure isotrope telles que des gravures chimiques en phase liquide ou en phase vapeur, ou bien des usinages ioniques ou des pulvérisations et inversement; ces deux derniers modes de gravure peuvent avantageusement être utilisés lorsque les matériaux constituant les différentes couches sont difficiles à graver, ce qui est notamment le cas pour des couches conductrices réalisées avec du cuivre, de l'argent, etc.

Enfin, l'épaisseur des différentes couches peut être modifiée.

Les différentes étapes des procédés conformément à l'invention ont l'avantage d'être toutes simples à réaliser et non critiques. Ces procédés qui constituent une approche différente de celle des procédés de fabrication des circuits intégrés généralement utilisés, sont fiables et reproductibles, ce qui n'est pas toujours le cas des procédés de l'art antérieur.

## Revendications

1. Procédé de fabrication sur un substrat semiconducteur (30) d'un circuit intégré comportant des composants actifs isolés électriquement les uns des autres et dans lequel les grilles (34a) de ces composants ne s'étendent pas au-dessus des isolations électriques (46a) servant à isoler lesdits composants entre eux, ce procédé comprenant, dans l'ordre, les étapes suivantes:

(a) recouvrement du substrat semiconducteur (30) d'une couche (32) d'un premier matériau isolant qui servira d'isolant de grille,

(b) dépôt sur la couche de premier matériau d'une couche (34) d'un second matériau conducteur ou semiconducteur dans laquelle seront réalisées les grilles (34a) des composants actifs,

(c) réalisation de l'isolant de champ (46a) du circuit servant à isoler électriquement les composants actifs les uns des autres,

(d) définition des dimensions des grilles (34a) des composants et des connexions électriques de ces grilles à réaliser, au moyen d'un premier masque négatif (50, 50a),

(e) réalisation, à l'aide de ce premier masque négatif (50, 50a), d'une première gravure de la couche (34) de second matériau sur une hauteur déterminée,

(f) réalisation d'une première gravure de l'isolant (46a) de champ, à l'aide du premier masque (50, 50a), sur une hauteur déterminée,

(g) élimination du premier masque négatif (50, 50a),

(h) dépôt sur l'ensemble de la structure obtenue d'une couche (56) d'un troisième matériau effaçant le relief de ladite structure,

(i) réalisation d'une gravure de la couche (56) de troisième matériau afin de ne garder de ce troisième matériau que dans les parties en creux dudit relief, la structure résultant de cette gravure présentant alors une surface plane,

(j) réalisation d'une seconde gravure de la couche (34) de second matériau restant jusqu'à mise à nu de la couche (32) de premier matériau entraînant ainsi la réalisation des grilles (34a) des composants actifs, la couche (56) de troisième matériau gravée servant de masque à cette gravure.

(k) réalisation des sources (57) et des drains (59) des composants par un premier dopage du substrat (30), ce premier dopage ayant une conductivité de type inverse de celle du substrat (30),

(l) réalisation de bords isolants (58a) sur les flancs des grilles (34a) des composants, et

(m) réalisation des contacts électriques et des connexions (62, 64, 70) du circuit.

2. Procédé de fabrication sur un substrat semi-conducteur (30) d'un circuit intégré comportant des composants actifs isolés électriquement les uns des autres et dans lequel les grilles (34a) de ces composants ne s'étendent pas au-dessus des isolations électriques (46a) servant à isoler lesdits composants entre eux, ce procédé comprenant, dans l'ordre, les étapes suivantes:

(a') recouvrement du substrat semiconducteur (30) d'une couche (32) d'un premier matériau isolant qui servira d'isolant de grille,

(b') dépôt sur la couche de premier matériau d'une couche (34) d'un second matériau conducteur ou semiconducteur dans laquelle seront réalisées les grilles (34a) des composants actifs,

(c') recouvrement de la couche de second matériau (34) par une couche (36) d'un matériau différent du second matériau et servant d'arrêt de gravure,

(d') dépôt sur la couche (36) du matériau d'arrêt de gravure, pour des raisons topographiques, d'une couche (38) d'un matériau complémentaire différent du matériau d'arrêt de gravure,

(e') réalisation de l'isolant de champ (46a) du circuit servant à isoler électriquement les composants actifs les uns des autres,

(f') définition des dimensions des grilles (34a) des composants et des connexions électriques de ces grilles à réaliser, au moyen d'un premier masque négatif (50, 50a),

(g') élimination des régions de la couche (38) de matériau complémentaire dépourvues dudit premier masque (50, 50a) jusqu'à mise à nu de la couche (36) du matériau d'arrêt de gravure,

(h') réalisation d'une première gravure de l'isolant (46a) de champ, à l'aide du premier masque (50, 50a), sur une hauteur déterminée,

(i') élimination du premier masque (50, 50a),

(j') dépôt sur l'ensemble de la structure obtenue d'une couche (56) d'un troisième matériau effaçant le relief de ladite structure,

(k') réalisation d'une gravure de la couche (56) de troisième matériau de façon à ne garder de ce troisième matériau que dans les parties en creux dudit relief, la structure résultant de cette gravure présentant alors une surface plane,

(l') élimination de la couche (38) restante de matériau complémentaire,

(m') réalisation d'une gravure des couches (36, 34) de matériau d'arrêt de gravure et de second matériau jusqu'à mise à nu de la couche (32) de premier matériau entraînant ainsi la réalisation des grilles (34a) des composants actifs, la couche (56) de troisième matériau gravée servant de masque à cette gravure,

(n') réalisation des sources (57) et des drains (59) des composants par un premier dopage du substrat (30), ce premier dopage ayant une conductivité de type inverse de celle du substrat (30),

(o') réalisation de bords isolants (58a) sur les flancs des grilles (34a) des composants, et

(p') réalisation des contacts électriques et des connexions (62, 64, 70) du circuit.

3. Procédé de fabrication selon la revendication 1 ou 2, caractérisé en ce que l'étape de réalisation de l'isolant de champ comprend les étapes successives suivantes:

(1) définition des régions du substrat (30) dans lesquelles seront réalisés les composants actifs, à l'aide d'un second masque positif (40),

(2) élimination des régions des différentes couches de matériau (32, 34, 36, 38) surmontant le substrat (30), dépourvues dudit second masque (40), de façon à mettre à nu les régions du substrat (30) non masquées,

(3) réalisation d'un second dopage du substrat (30) dans les régions mises à nu de celui-ci, ce dopage ayant une conductivité du même type que celle du substrat,

(4) élimination dudit second masque (40),

(5) dépôt d'une couche (46) d'un quatrième matériau isolant sur l'ensemble de la structure obtenue, et

(6) réalisation d'une gravure de la couche (46) de quatrième matériau de façon à mettre à nu la couche (34, 38) de matériau gravée se trouvant directement en-dessous de la couche (46) de quatrième matériau.

4. Procédé de fabrication selon la revendication 3, caractérisé en ce que l'on effectue, après l'étape (5), le dépôt sur la couche (46) de quatrième matériau d'une couche (48) d'un cinquième matériau isolant effaçant le relief de la couche (46) de quatrième matériau et en ce que l'on réalise l'étape (6) en gravant simultanément les couches (48, 46) des cinquième et quatrième matériaux avec des vitesses d'attaque identiques.

5. Procédé de fabrication selon la revendication 3, caractérisé en ce que l'on réalise, après l'étape (2), une gravure sur une hauteur déterminée des régions du substrat mises à nu, à l'aide du second masque (40).

6. Procédé de fabrication sur un substrat semi-conducteur (130) d'un circuit intégré comportant des composants actifs isolés électriquement les uns des autres et dans lequel les grilles (34a) de ces composants ne s'étendent pas au-dessus des isolations électriques (146a) servant à isoler lesdits composants entre eux, caractérisé en ce qu'il comprend, dans l'ordre, les étapes suivantes:

(α) réalisation de l'isolant de champ (146a) du circuit servant à isoler électriquement les composants actifs les uns des autres,

(β) recouvrement du substrat (130) d'un premier matériau isolant qui servira d'isolant de grille,

(γ) dépôt sur l'ensemble de la structure d'une couche (134) d'un second matériau conducteur ou semiconducteur dans laquelle seront réalisées les grilles des composants actifs,

(δ) réalisation d'une gravure de la couche (134) de second matériau de façon à mettre à nu l'isolant de champ (146a),

(ε) réalisation des grilles (34a) des composants actifs,

(ζ) réalisation des sources (57) et des drains (59) des composants par un premier dopage du substrat, ce premier dopage ayant une conductivité de type inverse de celle du substrat,

(η) réalisation de bords isolants (58a) sur les flancs des grilles des composants, et ·

(θ) réalisation des contacts électriques et des connexions (62, 64, 70) du circuit.

7. Procédé de fabrication selon la revendication 6, caractérisé en ce que l'on réalise les grilles des composants en effectuant les étapes successives suivantes:

– définition des dimensions des grilles (34a) des composants et des connexions électriques de ces grilles à réaliser, au moyen d'un premier négatif (50, 50a),

– réalisation, à l'aide de ce premier masque négatif (50, 50a), d'une première gravure de la couche (34) de second matériau sur une hauteur déterminée,

– réalisation d'une première gravure de l'isolant (46a) de champ, à l'aide du premier masque (50, 50a), sur une hauteur déterminée,

– élimination du premier masque négatif (50, 50a),

– dépôt sur l'ensemble de la structure obtenue d'une couche (56) d'un troisième matériau effaçant le relief de ladite structure,

– réalisation d'une gravure de la couche (56) de troisième matériau afin de ne garder de ce troisième matériau que dans les parties en creux dudit relief, la structure résultant de cette gravure présentant alors une surface plane, et

– réalisation d'une seconde gravure de la couche (34) de second matériau restant jusqu'à mise à nu de la couche (32) de premier matériau, la couche (56) de troisième matériau gravée servant de masque à cette gravure.

8. Procédé de fabrication selon la revendication 6, caractérisé en ce que l'étape (α) comprend les étapes successives suivantes:

– réalisation d'un deuxième dopage du substrat (130) ayant une conductivité du même type que celle du substrat,

– dépôt d'une couche (146) d'un quatrième matériau isolant sur l'ensemble du substrat semiconducteur (130),

– définition des régions du substrat dans lesquelles seront réalisés les composants actifs à l'aide d'un second masque négatif (140),

– élimination des régions de la couche (146) de quatrième matériau dépourvues dudit second masque négatif (140), et

– élimination dudit second masque négatif (140).

9. Procédé de fabrication selon l'une quelconque des revendications 6 à 8, caractérisé en ce que l'on effectue, après l'étape (γ), le dépôt sur la couche (134) de second matériau d'une couche (149) d'un cinquième matériau isolant effaçant le relief de la couche (134) de second matériau et en ce que l'on réalise l'étape (δ) en gravant simultanément les couches (134, 149) de second et de cinquième matériaux avec des vitesses d'attaque identiques.

10. Procédé de fabrication selon la revendication 1 ou 7, caractérisé en ce que, après l'élimination du premier masque négatif (50, 50a), on recouvre la structure d'une couche (54) d'un sixième matériau de façon à ne laisser du sixième matériau que sur les flancs gravés de la couche (34) de second matériau, obtenus lors de la première gravure de ladite couche.

11. Procédé de fabrication selon la revendication 2, caractérisé en ce que, entre les étapes (i') et (j'), on recouvre la structure d'une couche (54) d'un sixième matériau isolant puis on grave ladite couche (54) de sixième matériau de façon à ne laisser du sixième matériau que sur les flancs gravés de la couche (38) de matériau complémentaire.

12. Procédé de fabrication selon l'une quelconque des revendications 1 à 11, caractérisé en ce que l'on réalise les bords isolants sur les flancs des grilles des composants en effectuant les étapes successives suivantes:

– dépôt isotrope sur l'ensemble de la structure d'une couche (58) d'un septième matériau isolant,

– réalisation d'une gravure de cette couche (58) de septième matériau de façon à ne laisser du septième matériau que sur les flancs gravés de la structure, constituant ainsi des bandes (58) de septième matériau,

– réalisation d'un troisième masque négatif (60, 60a) sur la structure obtenue afin de définir les dimensions des contacts électriques des sources (57) et/ou des drains (59) des composants à réaliser,

– gravure des bandes isolantes non recouvertes par ledit troisième masque (60, 60a), sur toute ou partie de leur hauteur, et

– élimination du troisième masque (60, 60a).

13. Procédé de fabrication selon la revendication 3 ou 8, caractérisé en ce que l'on définit les dimensions des connexions à réaliser entre les sources (57) et/ou les drains (59) des composants lors de la définition des dimensions des grilles desdits composants au moyen dudit premier masque (50a) et en ce que l'on réalise, à l'aide de ce premier masque (50a), une seconde gravure de la couche (46) de quatrième matériau sur une hauteur déterminée.

14. Procédé de fabrication selon la revendications 12, caractérisé en ce que l'on définit les dimensions des connexions à réaliser entre les sources et/ou les drains des composants lors de la définition des dimensions des contacts électriques des sources et/ou des drains des composants au moyen dudit troisième masque (60) et en ce que l'on réalise à l'aide de ce troisième masque (60) une seconde gravure de la couche (46) de quatrième matériau sur une hauteur déterminée.

15. Procédé de fabrication selon l'une quelconque des revendications 1 à 14, caractérisé en ce que l'on réalise les contacts électriques et les connexions du circuit en effectuant les étapes successives suivantes:

– dépôt sur l'ensemble de la structure d'au moins une couche (62, 64) d'un huitième matériau conducteur dans laquelle seront réalisées les connexions,

— dépôt sur la couche (62, 64) de huitième matériau d'une couche (66) d'un neuvième matériau isolant effaçant le relief de ladite couche (62, 64) de huitième matériau,

— réalisation d'une gravure de la couche (66) de neuvième matériau afin de ne garder de ce neuvième matériau que dans les parties en creux dudit relief, la structure résultant de cette gravure ayant alors une surface plane,

— élimination des régions de la couche (62, 64) de huitième matériau non recouvertes de la couche (66) de neuvième matériau gravée, et

— élimination du restant de la couche de neuvième matériau.

16. Procédé de fabrication selon la revendication 15, caractérisé en ce que l'on dépose deux couches conductrices l'une au-dessus de l'autre pour réaliser lesdites connexions.

17. Procédé de fabrication selon l'une quelconque des revendications 1 à 16, caractérisé en ce que les connexions électriques (62, 64, 70) sont réalisées en métal.

18. Procédé de fabrication selon l'une quelconque des revendications 1 à 17, caractérisé en ce que le second matériau est un matériau choisi parmi le silicium polycristallin, les siliciures, le molybdène, le tantale, le titane et le tungstène.

19. Procédé de fabrication selon la revendication 3, caractérisé en ce que l'on effectue l'étape (2) en gravant successivement de façon anisotrope les différentes couches (32, 34, 36, 38) de matériau surmontant le substrat.

20. Procédé de fabrication selon la revendication 15, caractérisé en ce que l'on grave les couches de troisième (56), de quatrième (46, 146), cinquième (48, 149), septième (58) et/ou neuvième (66) matériaux de façon anisotrope.

**Patentansprüche**

1. Verfahren zur Herstellung eines Halbleitersubstrats (30) einer integrierten Schaltung, die voneinander elektrisch isolierte aktive Bauelemente enthält und bei der die Gates (34a) dieser Bauelemente sich nicht über die elektrischen Isolationen (46a) hinauserstrecken, die dazu dienen, diese Bauelemente voneinander zu isolieren, enthaltend in der nachfolgenden Reihenfolge die folgenden Schritte:

(a) Bedecken des Halbleitersubstrats (30) mit einer Schicht (32) aus einem ersten Isoliermaterial, das zur Gateisolierung dient,

(b) Niederschlagen einer Schicht (34) aus einem zweiten Leitermaterial, in dem die Gates (34a) der aktiven Bauelemente ausgebildet werden, auf der ersten Schicht,

(c) Ausbilden einer Feldisolierung (46a) der Schaltung, die dazu dient, die aktiven Bauelemente voneinander elektrisch zu isolieren,

(d) Bestimmen der Abmessungen der Gates (34a) der Bauelemente und der elektrischen Anschlüsse der herzustellenden Gates mittels einer ersten negativen Maske (50, 50a),

(e) Ausführung einer ersten Ätzung der Schicht (34) aus dem zweiten Material über eine vorbestimmte Höhe mit Hilfe dieser ersten negativen Maske (50, 50a),

(f) Ausführen einer ersten Ätzung der Feldisolation (46a) über eine vorbestimmte Höhe mit Hilfe der ersten Maske (50, 50a),

(g) Beseitigen der ersten negativen Maske (50, 50a),

(h) Niederschlagen einer Schicht (56) aus einem dritten Material auf der erhaltenen Gesamtstruktur, das das Relief der Gesamtstruktur einebnet,

(i) Ausführung einer Ätzung der Schicht (56) aus dem dritten Material derart, dass dieses dritte Material nur in den vertieften Bereichen des genannten Reliefs zurückbleibt, so dass die aus dieser Ätzung resultierende Struktur eine ebene Oberfläche aufweist,

(j) Ausführung einer zweiten Ätzung der zurückbleibenden Schicht (34) aus dem zweiten Material, bis die Schicht (32) aus dem ersten Material freigelegt ist, um auf diese Weise die Gates (34a) der aktiven Bauelemente auszubilden, wobei die Schicht (56) aus dem geätzten dritten Material als Maske für diese Ätzung dient,

(k) Erstellung der Sourceelektroden (57) und der Drainelektroden (59) der Bauelemente durch eine erste Dotierung des Substrats (30), wobei diese erste Dotierung eine Leitfähigkeit einer Art aufweist, die umgekehrt zu der des Substrats (30) ist,

(l) Erstellung von Isolationsrändern (58a) auf den Flanken der Gates (34a) der Bauelemente, und

(m) Herstellen der elektrischen Kontakte und der Verbindungen (62, 64, 70) der Schaltung.

2. Verfahren zur Herstellung einer integrierten Schaltung auf einem Halbleitersubstrat (30), die voneinander elektrisch isolierte aktive Bauelemente aufweist und in der sich die Gates (34a) dieser Bauelemente nicht über die elektrischen Isolationen (46a) hinauserstrecken, die dazu dienen, die genannten Bauelemente voneinander zu isolieren, enthaltend die nachfolgenden Schritte in der angegebenen Reihenfolge:

(a') Bedecken des Halbleitersubstrats (30) mit einer Schicht (32) aus einem ersten isolierenden Material, das der Gateisolation dient,

(b') Aufbringen einer Schicht (34) aus einem zweiten Leiter- oder Halbleitermaterial, in der die Gates (34a) der aktiven Bauelemente realisiert werden, auf die Schicht aus dem ersten Material,

(c') Bedecken der Schicht aus dem zweiten Material (34) mit einer Schicht (36) aus einem Material, das sich von dem zweiten Material unterscheidet und als Ätzsperre dient.

(d') Aufbringen einer Schicht (38) aus einem komplementären Material, das sich von dem Ätzsperrmaterial unterscheidet, auf die Schicht (36) aus dem Ätzsperrmaterial aus topographischen Gründen,

(e') Ausführung der Feldisolation (46a) der Schaltung, die dazu dient, die aktiven Bauelemente voneinander elektrisch zu isolieren,

(f') Bestimmen der Abmessungen der Gates (34a) der Bauelemente und der herzustellenden elektrischen Anschlüsse dieser Gates mittels einer ersten negativen Maske (50, 50a),

(g') Beseitigen der Bereiche der Schicht (38) aus dem komplementären Material, die von der ersten Maske (50, 50a) entblösst sind, bis die Schicht (36) aus dem Ätzsperrmaterial freigelegt ist,

(h') Ausführung einer ersten Ätzung der Feldisolierung (46a) mittels der ersten Maske (50, 50a) auf eine vorbestimmte Höhe,

(i') Beseitigen der ersten Maske (50, 50a),

(j') Aufbringen einer Schicht (56) aus einem dritten Material auf die erhaltene Gesamtstruktur, das das Relief der genannten Struktur einebnet,

(k') Ausführung einer Ätzung der Schicht (56) aus dem dritten Material derart, dass dieses dritte Material nur in den vertieften Bereichen des genannten Reliefs geschützt bleibt, so dass die aus dieser Ätzung resultierende Struktur eine im wesentlichen ebene Oberfläche zeigt,

(l') Beseitigen der verbliebenen Schicht (38) aus dem komplementären Material,

(m') Ausführung einer Ätzung der Schichten (36, 34) aus Ätzsperrmaterial und dem zweiten Material, bis die Schicht (32) aus dem ersten Material freigelegt ist, um auf diese Weise die Gates (34a) der aktiven Bauelemente auszubilden, wobei die Schicht (56) aus dem geätzten dritten Material als Maske für diese Ätzung dient,

(n') Ausbilden der Sourceelektroden (57) und der Drainelektroden (59) der Bauelemente durch eine erste Dotierung des Substrats (30), wobei die erste Dotierung einen Leitfähigkeitstyp aufweist, der invers zu dem des Substrats (30) ist,

(o') Ausbilden von Isolationsrändern (58a) auf den Flanken der Gates (34a) der Bauelemente, und

(p') Erstellen der elektrischen Kontakte und der Verbindungen (62, 64, 70) der Schaltung.

3. Herstellungsverfahren nach Anspruch 1 oder 2, dadurch gekennzeichnet, dass der Schritt der Feldisolation die folgenden Schritte umfasst:

(1) Bestimmung der Bereiche des Substrats (30), in denen die aktiven Bauelemente herzustellen sind, mittels einer zweiten positiven Maske (40),

(2) Beseitigung der verschiedenen Materialschichten (32, 34, 36, 38), die auf dem Substrat (30) liegen, von den Bereichen, die von der zweiten Maske (40) freigelassen sind, um die nicht maskierten Bereiche des Substrats (30) freizulegen,

(3) Ausführung einer zweiten Dotierung des Substrats (30) in den freigelegten Bereichen desselben, wobei diese Dotierung den gleichen Leitfähigkeitstyp aufweist, wie der des Substrats,

(4) Beseitigung der zweiten Maske (40),

(5) Aufbringen einer Schicht (46) aus einem vierten Isoliermaterial auf die erhaltene Gesamtstruktur, und

(6) Ausführung einer Ätzung der Schicht (46) aus dem vierten Material derart, dass die Schicht (34, 38) aus geätztem Material, die sich direkt unterhalb der Schicht (46) aus dem vierten Material befindet, freigelegt wird.

4. Herstellungsverfahren nach Anspruch 3, dadurch gekennzeichnet, dass man nach dem fünften Schritt auf die Schicht (46) aus dem vierten Material eine Schicht (48) aus einem fünften isolierenden Material aufbringt, die das Relief der Schicht (46) aus dem vierten Material einebnet, und dass man den sechsten Schritt dadurch ausführt, dass man die Schichten (48, 46) aus den fünften und vierten Materialien mit gleichen Angriffsgeschwindigkeiten gleichzeitig ätzt.

5. Herstellungsverfahren nach Anspruch 2, dadurch gekennzeichnet, dass man nach dem zweiten Schritt eine Ätzung auf eine vorbestimmte Höhe der freigelegten Substratbereiche mit Hilfe der zweiten Maske (40) ausführt.

6. Verfahren zur Herstellung einer integrierten Halbleiterschaltung, die elektrisch voneinander isolierte aktive Bauelemente enthält und in der die Gates (34a) dieser Bauelemente sich nicht über die elektrischen Isolationen (146a) hinauserstrecken, die dazu dienen, die genannten Bauelemente voneinander zu isolieren, auf einem Halbleitersubstrat, dadurch gekennzeichnet, dass es die nachfolgenden Schritte in der angegebenen Reihenfolge enthält:

(α) Ausführung einer Feldisolation (146a) der Schaltung, die dazu dient, die aktiven Bauelemente voneinander elektrisch zu isolieren,

(β) Bedeckung des Substrats (130) mit einer Schicht (132) aus einem ersten isolierenden Material, das der Isolation der Gates dient,

(γ) Aufbringen einer Schicht (134) aus einem zweiten Leiter- oder Halbleitermaterial, in der die Gates der aktiven Bauelemente herzustellen sind, auf die Gesamtstruktur,

(δ) Ausführung einer Ätzung der Schicht (134) aus dem zweiten Material derart, dass die Feldisolation (146a) freigelegt wird,

(ε) Herstellung der Gates (34a) der aktiven Bauelemente,

(ζ) Herstellung der Sourceelektroden (57) und der Drainelektroden (59) der Bauelemente durch eine erste Dotierung des Substrats, wobei diese Dotierung einen Leitfähigkeitstyp hat, der umgekehrt zu dem des Substrats ist,

(η) Herstellung von Isolierrändern (58a) auf den Flanken der Gates der Bauelemente, und

(θ) Herstellung der elektrischen Kontakte und der Verbindungen (62, 64, 70) der Schaltung.

7. Herstellungsverfahren nach Anspruch 6, dadurch gekennzeichnet, dass man die Gates der Bauelemente dadurch herstellt, dass die folgenden Schritte aufeinanderfolgend ausgeführt werden:

— Bestimmung der Abmessungen der Gates (34a) der Bauelemente und der elektrischen Verbindungen dieser herzustellenden Gates mittels einer ersten negativen Maske (50, 50a),

— Ausführung einer ersten Ätzung der Schicht (34) aus dem zweiten Material auf eine vorbestimmte Höhe mittels der ersten negativen Maske (50, 50a),

— Ausführen einer ersten Ätzung der Feldisolation (46a) auf eine vorbestimmte Höhe mittels der

14

ersten Maske (50, 50a),

– Beseitigung der ersten negativen Maske (50, 50a),

– Aufbringung einer Schicht (56) aus einem dritten Material auf die Gesamtanordnung der erhaltenen Struktur, die das Relief der genannten Struktur einebnet,

– Ausführung einer Ätzung der Schicht (56) aus dem dritten Material, um das dritte Material nur in den vertieften Bereichen des genannten Reliefs zu schützen, so dass die aus dieser Ätzung resultierende Struktur eine ebene Oberfläche aufweist, und

– Ausführung einer zweiten Ätzung der Schicht (34) aus dem zurückgebliebenen zweiten Material, bis die Schicht (32) aus dem ersten Material freigelegt ist, wobei die geätzte Schicht (56) aus dem dritten Material als Maske für diese Ätzung dient.

8. Herstellungsverfahren nach Anspruch 6, dadurch gekennzeichnet, dass der Schritt (α) die nachfolgenden Schritte umfasst:

– Ausführung einer zweiten Dotierung des Substrats (130), die den gleichen Leitfähigkeitstyp wie die des Substrats aufweist,

– Aufbringung einer vierten isolierenden Schicht (146) auf die Halbleitersubstratanordnung (130),

– Bestimmen der Bereiche des Substrats, in denen die aktiven Bauelemente herzustellen sind, mit Hilfe einer zweiten negativen Maske(140),

– Beseitigung der Bereiche der Schicht (146) aus dem vierten Material, die von der zweiten negativen Maske (140) unbedeckt gelassen sind, und

– Beseitigung der genannten zweiten negativen Maske (140).

9. Herstellungsverfahren nach einem der Ansprüche 6 bis 8, dadurch gekennzeichnet, dass man nach dem Schritt (γ) auf der Schicht (134) aus dem zweiten Material eine Schicht (149) aus einem fünften isolierenden Material aufbringt, die das Relief der Schicht (134) aus dem zweiten Material glättet, und dass man den Schritt (δ) dadurch ausführt, dass man die Schichten (134, 149) aus den zweiten und fünften Materialien mit gleichen Angriffsgeschwindigkeiten gleichzeitig ätzt.

10. Herstellungsverfahren nach Anspruch 1 oder 7, dadurch gekennzeichnet, dass man nach der Beseitigung der ersten negativen Maske (50, 50a) die Struktur mit einer Schicht (54) aus einem sechsten Material bedeckt, um von dem sechsten Material nur die geätzten Flanken der Schicht (34) aus dem zweiten Material zurückzulassen, die man durch die erste Gravur der genannten Schicht erhält.

11. Herstellungsverfahren nach Anspruch 2, dadurch gekennzeichnet, dass man zwischen den Schritten (i') und (j') die Struktur mit einer Schicht (54) aus einem sechsten isolierenden Material bedeckt, man dann die genannte Schicht (54) aus dem sechsten Material so graviert, dass von dem sechsten Material nur die geätzten Flanken der Schicht (38) aus dem komplementären Material zurückgelassen werden.

12. Herstellungsverfahren nach einem der Ansprüche 1 bis 11, dadurch gekennzeichnet, dass man die isolierenden Ränder auf den Flanken der Gates der Bauelemente durch Ausführung der nachfolgenden Schritte herstellt:

– Isotrope Aufbringung einer Schicht (58) aus einem siebenten isolierenden Material auf die Gesamtstruktur,

– Ausführung einer Ätzung dieser Schicht (58) aus dem siebenten Material in der Weise, dass von dem siebenten Material nur die geätzten Flanken der Struktur zurückbleiben, die so Bänder (58a) aus dem siebenden Material bilden,

– Herstellung einer dritten negativen Maske (60, 60a) auf der erhaltenen Struktur, um die Abmessungen der elektrischen Kontakte der Sourceelektroden (57) und/oder der Drainelektroden (59) der herzustellenden Bauelemente zu bestimmen,

– Ätzen der nicht abgedeckten isolierenden Bänder durch die genannte dritte Maske (60, 60a) über die gesamte oder über einen Teil ihrer Höhe, und

– Beseitigung der dritten Maske (60, 60a).

13. Herstellungsverfahren nach Anspruch 3 oder 8, dadurch gekennzeichnet dass man die Abmessungen der zwischen den Sourceelektroden (57) und/oder den Drainelektroden (59) der Bauelemente herzustellenden Verbindungen bei der Bestimmung der Abmessungen der Gates der genannten Bauelemente mittels der genannten ersten Maske (50a) bestimmt und dass man mit Hilfe der genannten ersten Maske (50a) eine zweite Ätzung der Schicht (46) aus dem vierten Material auf eine vorbestimmte Höhe ausführt.

14. Herstellungsverfahren nach Anspruch 12, dadurch gekennzeichnet, dass man die Abmessungen der zwischen den Sourceelektroden und/oder den Drainelektroden der Bauelemente herzustellenden Verbindungen bei der Bestimmung der Abmessungen der elektrischen Kontakte der Sourceelektroden und/oder der Drainelektroden der Bauelemente mittels der dritten Maske (60) bestimmt und dass man mit Hilfe dieser dritten Maske (60) eine zweite Ätzung der Schicht (46) aus dem vierten Material auf eine vorbestimmte Höhe ausführt.

15. Herstellungsverfahren nach einem der Ansprüche 1 bis 14, dadurch gekennzeichnet, dass man die elektrischen Kontakte und die Verbindungen der Schaltung dadurch herstellt, dass man die nachfolgenden aufeinanderfolgenden Schritte ausführt:

– Aufbringen wenigstens einer Schicht (62, 64) aus einem achten Leitermaterial, in der die genannten Verbindungen herzustellen sind, auf die Gesamtstruktur,

– Aufbringen einer Schicht (66) aus einem neunten isolierenden Material auf die Schicht (62, 64) aus dem achten Material, die das Relief der genannten Schicht (62, 64) aus dem achten Material einebnet,

– Ausführung einer Ätzung der Schicht (66) aus dem neunten Material, um von dem neunten Material nur die vertieften Bereiche des genannten Reliefs zu schützen, so dass die aus dieser Ätzung resultierende Struktur eine ebene Oberfläche hat,

– Beseitigung der Bereiche der Schicht (62, 64) aus dem achten Material, die nicht von der geätzten Schicht (66) aus dem neunten Material bedeckt sind, und

– Beseitigung des Restes der Schicht aus dem neunten Material.

16. Herstellungsverfahren nach Anspruch 15, dadurch gekennzeichnet, dass man zwei leitfähige Schichten übereinander aufbringt, um die genannten Verbindungen herzustellen.

17. Herstellungsverfahren nach einem der Ansprüche 1 bis 16, dadurch gekennzeichnet, dass die elektrischen Verbindungen (62, 64, 70) aus Metall hergestellt werden.

18. Herstellungsverfahren nach einem der Ansprüche 1 bis 17, dadurch gekennzeichnet, dass das zweite Material ein Material ist, das unter polykristallinem Silicium, Siliciden, Molybdän, Tantal, Titan und Wolfram ausgewählt ist.

19. Herstellungsverfahren nach Anspruch 3, dadurch gekennzeichnet, dass man den zweiten Schritt dadurch ausführt, dass man die verschiedenen Materialschichten (32, 34, 36, 38), die sich auf dem Substrat befinden, nacheinander anisotrop ätzt.

20. Herstellungsverfahren nach Anspruch 15, dadurch gekennzeichnet, dass man die dritte (56), vierte (46, 146), fünfte (48, 149), siebente (58) und/oder neunte (66) Materialschicht anisotrop ätzt.

## Claims

1. Process for the production, on a semiconductor substrate (30), of an integrated circuit having reciprocally electrically insulated components in which the gates (34a) of said components do not extend above the electrical insulations (46a) used for the reciprocal insulation of said components, said process being characterized in that it comprises, in sequence, the following stages:

(a) covering a semiconductor substrate (30) with a layer (32) of a first insulating material, serving as the gate insulant,

(b) deposition on the layer (34) of the first material a layer of a second semiconductor or conductor material in which will be formed the gates (34a) of the active components,

(c) formation of the field insulant (46a) of the circuit used for electrically insulating the active components from one another,

(d) definition of the dimensions of the gates (34a) of the components and the electrical connections of said gates to be produced by means of a first negative mask (50, 50a),

(e) production with the aid of said first negative mask (50, 50a) of a first etching of layer (34) of the second material over a predetermined height,

(f) carrying out a further etching of the field insulant (46a) using the first mask (50, 50a) over a predetermined height,

(g) elimination of the first negative mask (50, 50a),

(h) deposition on the complete structure obtained of a layer (56) of a third material cancelling out the relief of said structure,

(i) carrying out an etching of the third material layer (56), so that said third material is only retained in the hollowed out portions of said relief, the structure resulting from said etching then having a planar surface,

(j) carrying out a second etching of the remaining second material layer (34) up to the exposure of the first material layer (32), thus leading to the formation of the gates (34a) of the active components, the etched third material layer (56) serving as a mask for said etching,

(k) forming the sources (57) and drains (59) of the components by a first doping of substrate (30), said first doping having a conductivity of the reverse type to that of substrate (30),

(l) forming insulating edges (58a) on the sides of the gates (34a) of the components, and

(m) producing electrical contacts and connections (62, 64, 70) of the circuit.

2. Process for the production, on a semiconductor substrate (30), of an integrated circuit having reciprocally electrically insulated components in which the gates (34a) of said components do not extend above the electrical insulations (46a) used for the reciprocal insulation of said components, said process being characterized in that it comprises, in sequence, the following stages:

(a') covering a semiconductor substrate (30) with a layer (32) of a first insulating material, serving as the gate insulant,

(b') deposition on the layer (34) of the first material a layer of a second semiconductor or conductor material in which will be formed the gates (34a) of the active components,

(c') covering the second material layer (34) by a layer (36) of a material differing from the second material and serving to stop etching,

(d') deposition on the layer (36) of the etching stopping material, for topographical reasons, of a layer (38) of a complementary material differing from the etching stopping material,

(e') producing the field insulant (46a) of the circuit used for electrically insulating the active components from one another,

(f') definition of the dimensions of the gates (34a) of the components and the electrical connections of these gates to be produced by means of a first negative mask (50, 50a),

(g') elimination of the regions of the complementary material layer (30) freed from said first mask (50, 50a) up to the exposure of the layer (36) of etching stopping material,

(h') carrying out a first etching of the field insulant (46a) with the aid of the first mask (50, 50a) over a predetermined height,

(i') elimination of the first mask (50, 50a),

(j') deposition on the complete structure obtained of a layer (56) of a third material cancelling out the relief of said structure,

(k') carrying out an etching of the third material layer (56), so as to only retain said third material in the hollowed out portions of said relief, the structure resulting from said etching then having a planar surface,

(l') elimination of the remaining layer (38) of complementary material,

(m') carrying out the etching of the layers (36, 34) of etching stopping material and second material up to the exposure of the first material layer (32), thus leading to the formation of the gates (34a) of the active components, the etched third material layer (56) serving as a mask for said etching,

(n') formation of the sources (57) and drains (59) of the components by a first doping of the substrate (30), said first doping having a conductivity which is the reverse of that of substrate (30),

(o') forming the insulating edges (58a) on the sides of the gates (34a) of the components, and

(p') producing electrical contacts and connections (62, 64, 70) of the circuit.

3. Production process according to claims 1 or 2, characterized in that the stage of producing the field insulant comprises the following successive stages:

(1) definition of the regions of the substrate (30) in which will be formed the active components with the aid of a second positive mask (40),

(2) elimination of the regions of the different material layers (32, 34, 36, 38) surmounting the substrate (30) and free from said second mask (40), so as to expose the unmasked regions of substrate (30),

(3) carrying out of a second doping of substrate (30) in the exposed regions thereof, said doping having a conductivity of the same type as that of the substrate,

(4) elimination of said second mask (40),

(5) deposition of a layer (46) of a fourth insulating material on the complete structure obtained, and

(6) carrying out an etching of the fourth material layer (46), so as to expose the etched material layer (34, 38) located directly below the fourth material layer (46).

4. Production process according to claims 3, characterized in that following stage 5, deposition takes place on the fourth material layer (46) of a fifth insulating material layer (48) cancelling out the relief of fourth material layer (46) and in that stage 6 is carried out by simultaneously etching the fifth and fourth layers (48, 46) at identical etching speeds.

5. Production process according to claim 3, characterized in that following stage 2, etching takes place over a predetermined heigth of the exposed regions of the substrate using the second mask (40).

6. Process for the production on a semiconductor substrate (130) of an integrated circuit having active components which are electrically insulated from one another in which the gates (34a) of said components do not extend above the electrical insulations (146a) used for insulating said components from one another, characterized in that it comprises, in sequence, the following stages:

(α) producing the field oxide (146a) of the circuit used for electrically insulating the active components from one another,

(β) covering the substrate (130) with a layer (134) of a first insulating material,

(γ) depositing on the complete structure a layer (134) of a semiconductor or conductor material in which will be formed the gates of the active components,

(δ) etching the layer (134) of second material so as to expose the field oxide (146a),

(ε) producing the gates (34a) of the active components, (ζ) producing the sources (57) and drains (59) of the components by a first doping of the substrate, said first doping having a reverse conductivity to that of the substrate,

(η) producing insulating edges (58a) on the edges of the gates of the components, and

(θ) producing electrical contacts and connections (62, 64, 70) of the circuit.

7. Production process according to claim 6, characterized in that the gates of the components are produced by carrying out the following successive stages:

— definition of the dimensions of the gates (34a) of the components and the electrical connections of said gates to be produced using a first negative mask (50, 50a),

— producing with the aid of said first negative mask (50, 50a) a first etching of the second material layer (34) over a predetermined height,

— carrying out of a first etching of the field insulant (46a) with the aid of the first mask (50, 50a) over a predetermined height,

— elimination of the first negative mask (50, 50a),

— deposition on the complete structure obtained of a third material layer (56) cancelling out the relief of said structure,

— carrying out an etching of the third material layer (56) in order to only retain said third material in the hollowed out parts of said relief, the structure resulting from said etching then having a planar surface, and

— carrying out a second etchingof the remaining second material layer (34) up to the exposure of the first material layer (32), the etched third material layer (56) serving as a mask for said etching.

8. Production process according to claim 6, characterized in that stage (α) comprises the following successive stages:

— carrying out a second doping of substrate (130) having a conductivity of the same type as that of the substrate,

— deposition of a fourth insulating material layer (146) on the complete semiconductor substrate (130),

— definition of the regions of the substrate in which will be produced the active components with the aid of the second negative mask (140),

– elimination of the regions of the fourth material layer (146) freed from said second negative mask (140) and

– elimination of said second negative mask (140).

9. Production process according to any one of the claims 6 to 8, characterized in that, after stage (γ), on layer (134) of second material is deposited a layer (149) of a fifth insulating material obliterating the relief of layer (134) of second material and in that stage (δ) is performed by simultaneously etching layers (134, 149) of the second and fifth materials at identical etching speeds.

10. Production process according to claims 1 or 7, characterized in that, following the elimination of the first negative mask (50, 50a), the structure is covered with a sixth material layer (54), so as only to leave the sixth material on the etched sides of the second material layer (34) obtained during the first etching of said layer.

11. Production process according to claim 2, characterized in that between stages (i') and (j'), the structure is covered with a sixth insulating material layer (54) and then said sixth material laye (54) is etched so as to only leave said sixth material on the etched sides of the complementary material layer (38).

12. Production process according to any one of the claims 1 to 11, characterized in that the insulating edges are formed on the sides of the gates of the components by carrying out the following successive stages:

– isotropic deposition on the complete structure of a seventh insulating material layer (58),

– carrying out the etching of said seventh material layer (58), so as to only leave the seventh material on the etched sides of the structure, thus constituting seventh material strips (58a),

– production of a third negative mask (60, 60a) on the structure obtained, in order to define the dimensions of the electrical contacts o the sources (57) and/or drains (59) of the components to be produced,

– etching the insulating strips not covered by said third mask (60, 60a) over all or part of their height and

– elimination ot the third mask (60, 60a).

13. Production process according to claims 3 or 8, characterized in that definition takes place of the dimensions of the connections to be produced between the sources (57) and/or drains (59) of the components during the definition of the dimensions of the gates of said components by means of said first mask (50a) and in that, with the aid of said first mask (50a), a second etching of the fourth material layer (46) is carried out over a predetermined height.

14. Production process according to claim 12, characterized in that the dimensions of the connections to be produced between the sources and/or drains of the components is defined during the definition of the dimensions of the electrical contacts of the sources and/or drains of the components by means of said third mask (60) and in that the latter is used for carrying out a second etching of the fourth material layer (46) over a predetermined height.

15. Production process according to any one of the claims 1 to 14, characterized in that the electrical contacts and connections of the circuit are obtained by carrying out the following successive stages:

– deposition on the complete structure of at least one eighth conductive material layer (52, 64) in which the connections will be subsequently formed,

– deposition on the eighth material layer (62, 64) of a ninth insulating material layer (66) cancelling out the relief of said eighth material layer (62, 64),

– carrying out the etching of the ninth material layer (66), so as to only retain said ninth material in the hollowed out portions of said relief, the structure resulting from said etching then having a planar surface,

– elimination of the regions of the eighth material layer (62, 64) not covered by the etched ninth material layer (66) and

– elimination of the remainder of the ninth material layer.

16. Production process according to claim 15, characterized in that two conductive layers are deposited one above the other to obtain said connections.

17. Production process according to any one of the claims 1 to 16, characterized in that the electrical connections (62, 64, 70) are of metal.

18. Production process according to any one of the claims 1 to 17, characterized in that the second material is chosen from among polycrystalline silicon, silicides, molybdenum, tantalum, titanium and tungsten.

19. Production process according to claim 3, characterized in that stage (2) is effected by successively anisotropically etching the different material layers (32, 34, 36, 38) surmounting the substrate.

20. Production process according to claim 15, characterized in that the third (56), fourth (46, 146), fifth (48, 149), seventh (58) and/or ninth (66) material layers are anisotropically etched.

FIG.1

FIG.2

FIG.3

FIG.4

FIG.5

FIG.6

FIG.7

FIG.7a

FIG.8

FIG.9

FIG.10

FIG.11

3 / 5
54a    56    54a    58
46a    32    46a
57  34a  59
-30-

FIG.12

54a    540
58a    56    58a
46a    46a
57  32  340  59
-30-

FIG.13

60    58a    56    61    60
58a
46a    46a
57  32  34a  59  -30-

FIG.13a

60a    58a    56    61    60a
B
46a    46a
57  32  34a  59  -30-

FIG.14

58a    56
A
46a    46a
57  32  34a  59  -30-

23

FIG. 15

FIG. 16

FIG. 17

**FIG.18**

140    146 (SiO₂)

_130_    Si-p

**FIG.19**

149    134 (Si poly)

146a    _130_    132    146a

**FIG.20**

146a    146a

134    132    _130_

**FIG.21**

46a    62    64

32    340    460

_30_